# EUROPÄISCHE PATENTSCHRIFT

(11) **EP 2 364 581 B1**
(45) Veröffentlichungstag und Bekanntmachung des Hinweises auf die Patenterteilung: **01.11.2017**
(21) Anmeldenummer: 09783528.4
(22) Anmeldetag: 29.09.2009
(51) Int. Cl.: H05K 7/14, H05K 7/20, H01L 23/473

(54) **STROMRICHTERMODUL MIT GEKÜHLTER VERSCHIENUNG**
RECTIFIER MODULE WITH COOLED BUSBAR
MODULE REDRESSEUR DE COURANT À SYSTÈME DE BARRES REFROIDI

(30) Priorität: 10.12.2008 DE 102008061488
(43) Veröffentlichungstag der Anmeldung: 14.09.2011
(73) Patentinhaber: Siemens Aktiengesellschaft, 80333 München (DE)
(72) Erfinder: HENTSCHEL, Stefan, 91085 Weisendorf (DE); PONATH, Harald, 96114 Hirschaid (DE)
(86) Internationale Anmeldenummer: PCT/EP2009/062589
(87) Internationale Veröffentlichungsnummer: WO 2010/066484

(56) Entgegenhaltungen:
- EP-A2- 1 781 076
- US-A- 5 923 085
- US-A1- 2004 060 689
- US-B1- 6 313 991

## Beschreibung

Die Erfindung bezieht sich auf ein Stromrichtermodul gemäß Oberbegriff des Anspruchs 1.

Gattungsgemäße Stromrichtermodule, insbesondere für höhere Leistungen, sind im Handel erhältlich. Bei derartigen Stromrichtermodulen sind dessen Leistungshalbleitermodule, insbesondere abschaltbare Leistungshalbleitermodule, mit Anschlüssen des Stromrichtermoduls niederinduktiv verschient. Dies wird dadurch erreicht, dass die verwendeten Stromschienen flächig ausgeführt und übereinander zu einem Stromschienenstapel gestapelt sind. Jeweils zwischen zwei flächigen Stromschienen ist eine flächig ausgeführte Isolierschicht angeordnet. Diese Isolierschichten überragen die flächigen Stromschienen, damit Grenzwerte für Luft- und Kriechstrecken eingehalten werden können. Somit weist eine derartige niederinduktive Verschienung mindestens zwei Stromschienen und mindestens eine Isolierschicht auf. Um die Verschienung der verwendeten Leistungshalbleitermodule des Stromrichtermoduls möglichst kompakt zu gestalten, ist dieses Schienenpaket laminiert. Durch die verwendeten Materialien, insbesondere das Laminiermaterial, weist diese Verschienung eine Temperaturgrenze von beispielsweise 105° C auf.

Da bei den im Handel erhältlichen Leistungshalbleitermodulen, insbesondere abschaltbare Leistungshalbleitermodule, beispielsweise **I**nsulated-**G**ate-**B**ipolar-**T**ransistor (IGBT), die Stromtragfähigkeit stetig zunimmt, steigt dementsprechend die Stromdichte in den Stromschienen einer Verschienung, insbesondere einer laminierten Verschienung, eines Stromrichtermoduls an. Dies hat eine quadratische Zunahme der Verluste in der Verschienung zur Folge, so dass die Temperatur dieser Verschienung ebenfalls zunimmt. Die Grenztemperatur einer Verschienung wird durch die eingesetzten Materialien der Isolierschichten und des Laminiermaterials bestimmt. Bevorzugt kommen derzeit in Stromrichtermodulen mit einer Isolierfolie laminierte Verschienungen zum Einsatz. Hier setzt das Laminiermaterial der laminierten Verschienung eine Temperaturgrenze. Für Stromrichteranwendungen bedeutet dies eine Leistungsbegrenzung, die nicht mehr durch die eingesetzten Leistungshalbleitermodule, sondern durch die maximale Grenztemperatur des entsprechenden Laminiermaterials der Verschienung bedingt ist.

Naheliegende Lösungen dieses Problems sind einerseits, den Querschnitt einer jeden Stromschiene der Verschienung zu erhöhen, und andererseits diese Verschienung zu kühlen, beispielsweise durch Eigenkonvektion. Durch die Erhöhung der Querschnitte der Stromschienen der Verschienung ist eine derartige Verschienung nicht nur kostspieliger, sondern weist auch ein höheres Gewicht auf. Um die Verschienung durch Eigenkonvektion zu kühlen, muss diese in einem Stromrichtergerät derart angeordnet werden, dass ein Kühlluftstrom über diese Verschienung fließen kann.

Aus der WO 2005/109505 A1 ist eine Leistungshalbleiterschaltung bekannt, deren Verschienung gekühlt wird. Bei dieser Leistungshalbleiterschaltung ist wenigstens ein Modul auf einer als Plus- oder Minus-Platte dienenden plattenförmigen Stromschiene außenseitig aufgelötet. Die Plus- bzw. Minus-Schienen sind üblicherweise als oberste bzw. unterste Platte eines Platten-Verschienungspakets angeordnet. Diese Deckschiene, auf der das Modul aufgebracht ist, wird direkt von einer Kühleinrichtung gekühlt, wobei diese Kühleinrichtung als Luft- oder Flüssigkeitskühlung ausgebildet ist. Diese Kühleinrichtung ist sandwichartig zwischen der Deckschiene und unter Zwischenlage einer Isolierung einer weiteren, in einer parallelen Ebene liegenden plattenförmigen Stromschiene angeordnet. Ferner ist unter Zwischenlage einer weiteren Isolierschicht eine unterseitige Stromschiene vorgesehen. Diese Stromschienen bilden zusammen mit der Kühleinrichtung eine sehr kompakte Anordnung. Die Elemente dieses Verschienungspaketes sind durch Laminieren miteinander verbunden. Da es sich bei dieser Leistungshalbleiterschaltung um einen Wechselrichter handelt, sind unter diesem Verschienungspaket zwei Zwischenkreiskondensatoren angeordnet, die über Verschraubungen mit der oberen bzw. unteren Stromschiene verbunden sind.

Aus der DE 10 2007 003 875 A1 ist ein Stromrichtermodul mit wenigstens zwei Leistungshalbleitermodulen bekannt, die thermisch leitend mit einem Kühlkörper mechanisch verbunden und mittels einer laminierten Verschienung untereinander elektrisch verschaltet sind. Wenigstens eine Stromschiene dieser laminierten Verschienung ist mittels wenigstens eines elektrisch isolierenden und thermisch leitenden Stützelements mit dem Kühlkörper thermisch verknüpft. Durch diese Stützelemente ist wenigstens eine Stromschiene der laminierten Verschienung an den Kühlkörper thermisch angebunden. Die Höhe der abzuführenden Wärme bestimmt die Anzahl der thermisch leitenden Stützelemente. Mittels dieser Stützelemente wird die laminierte Verschienung in den Randbereichen ebenfalls abgestützt. Mittels dieser thermisch leitenden Stützelemente ist die Menge der von der laminierten Verschienung abzuführenden Wärmemenge beschränkt.

Aus der US 5,923,085 A ist eine Stromrichtereinheit bekannt, die eine Vielzahl von Halbleitermodulen und zwei Kondensatorbänke aufweist. Diese Halbleitermodule werden jeweils mittels einer DC-Buseiheit mit einer Kondensatorbank elektrisch leitend verbunden. Außerdem sind diese Halbleitermodule mit einer Flüssigkeits-Kühlanordnung thermisch leitend verbunden. Die beiden Kondensatorbänke sind einander räumlich gegenüber angeordnet, wobei zwischen diesen beiden Kondensatorbänken die Flüssigkeits-Kühlanordnung mit den Halbleitermodulen und beidseitig dieser Kühlanordnungen jeweils eine DC-Buseinheit angeordnet sind. Die beiden Stromschienen einer jeden DC-Buseinheit sind jeweils als Hohlkörper ausgebildet, deren Inneres von einer Kühlflüssigkeit durchströmt wird. Die Kühlkreisläufe der Stromschienen einer jeden DC-Buseinheit sind mit dem Kühlkreislauf der Flüssigkeits-Kühlanordnung der Halbleitermodule verbunden. Die Verwendung von innengekühlten Stromschienen für eine Gleichspannungs-Verschienung ist aufwendig und kostenintensiv.

Der Erfindung liegt nun die Aufgabe zugrunde, ein Stromrichtermodul anzugeben, dessen Verschienung mit einfachen Mitteln entwärmt werden kann, wobei dieses Stromrichtermodul nicht neu entflechtet bzw. neu konstruiert werden muss.

Diese Aufgabe wird mit dem kennzeichnenden Merkmal des Anspruchs 1 erfindungsgemäß gelöst.

Dadurch, dass eine Kühlmittelleitung auf einer Oberfläche einer Stromschiene der Verschienung eines Stromrichtermoduls thermisch mit dieser leitend verbunden ist, kann eine in der Verschienung entstandene Verlustleistung abgeführt werden. Dadurch wird die Temperatur der Verschienung herabgesetzt, wodurch die verwendeten Leistungshalbleitermodule leistungsmäßig ausgeschöpft werden können. Das heißt, dass das erfindungsgemäße Stromrichtermodul gegenüber einem handelsüblichen Stromrichtermodul eine höhere Leistung auf weist. Somit wird die Leistung eines Stromrichtermoduls nicht mehr durch die maximale Grenztemperatur eines verwendeten Isoliermaterials der Verschienung, sondern wieder durch das Leistungsvermögen der verwendeten Leistungshalbleitermodule bestimmt.

Außerdem sind die Stromschienen der Verschienung und diese Kühlmittelleitung des erfindungsgemäßen Stromrichtermoduls miteinander laminiert. Dadurch bilden die Stromschienen der Verschienung und die Kühlmittelleitung eine Bauform, deren Einzelteile räumlich zueinander fixiert sind. Dadurch kann man diese gekühlte Verschienung wie jede im Handel erhältliche laminierte Verschienung handhaben.

Bei einer weiteren vorteilhaften Ausführungsform des Stromrichtermoduls nach der Erfindung ist die Kühlmittelleitung flüssigkeitsmäßig mit dem Flüssigkeits-Kühlkörper des Stromrichtermoduls verbunden. Somit wird die Kühlmittelleitung aus dem Flüssigkeits-Kühlkörper des Stromrichtermoduls, der auch als Primärkreislauf bezeichnet wird, versorgt. Dies hat den Vorteil, dass das Stromrichtermodul von seinen Anschlüssen unverändert bleibt.

Bei einer weiteren vorteilhaften Ausführungsform des Stromrichtermoduls nach der Erfindung ist die Kühlmittelleitung entlang einer Oberfläche der Verschienung mäanderförmig angeordnet. Dadurch wird erreicht, dass annähernd die gesamte Oberfläche der Verschienung des Stromrichtermoduls entwärmt werden kann.

Bei einer weiteren vorteilhaften Ausführungsform des Stromrichtermoduls nach der Erfindung sind zwei Kühlmittelleitungen auf der Oberfläche der Verschienung des Stromrichtermoduls derart angeordnet, dass jeweils eine Kühlmittelleitung in Flucht jeweils eines Leistungshalbleitermoduls angeordnet ist. Jede Kühlmittelleitung kann vorzugsweise in einem solchen Bereich mäanderförmig verlaufen. Damit jede Kühlmittelleitung unabhängig von der anderen Kühlmittelleitung einen Verschienungsbereich in Flucht eines Leistungshalbleitermoduls entwärmen kann, sind diese beiden Kühlmittelleitungen flüssigkeitsmäßig zueinander und zum Flüssigkeits-Kühlkörper des Stromrichtermoduls parallel geschaltet.

Zur weiteren Erläuterung der Erfindung wird auf die Zeichnung Bezug genommen, in der eine Ausführungsform schematisch veranschaulicht ist.
- FIG 1: zeigt ein handelsübliches Stromrichtermodul und in der
- FIG 2: ist eine Verschienung eines Stromrichtermoduls nach der Erfindung dargestellt.

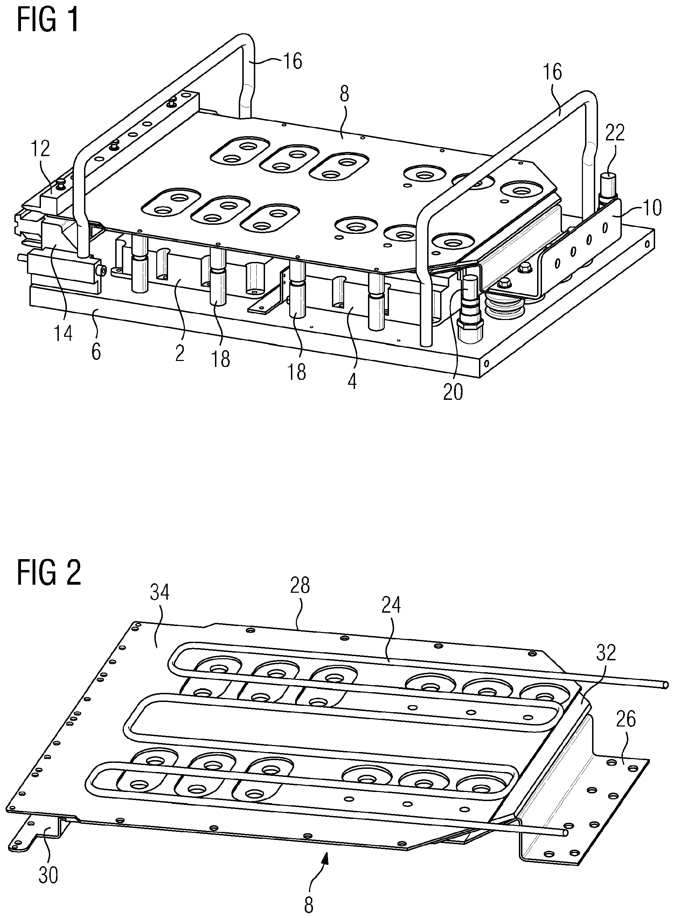

In der Figur 1, die eine perspektivische Sicht eines im Handel erhältlichen Stromrichtermoduls darstellt, sind mit 2 und 4 jeweils ein Leistungshalbleitermodul, insbesondere ein abschaltbares Leistungshalbleitermodul, beispielsweise ein Insulated-Gate-Bipolar-Transistor (IGBT), mit 6 ein Flüssigkeits-Kühlkörper, mit 8 eine Verschienung, mit 10 ein Lastanschluss, mit 12 und 14 jeweils ein Gleichspannungsanschluss, mit 16 ein Bügel und mit 18 Stützelemente bezeichnet. Außerdem sind in dieser Darstellung ein Kühlmittelzu- und -ablauf mit 20 und 22 bezeichnet.

Die beiden Leistungshalbleitermodule 2 und 4 sind mechanisch mit dem Flüssigkeits-Kühlkörper 6 lösbar befestigt. Die Verschienung 8 kann zwei Stromschienen, beispielsweise eine Plus-Stromschiene und eine Last-Stromschiene bzw. eine Last-Stromschiene und eine Minus-Stromschiene, oder drei Stromschienen, beispielsweise eine Plus-, Last- und Minusstromschiene, aufweisen. Die Anzahl der Stromschienen der Verschienung 8 hängt von der elektrischen Verdrahtung der beiden Leistungshalbleitermodule 2 und 4 ab. Sind diese beiden Leistungshalbleitermodule 2 und 4 elektrisch parallel geschaltet, so weist die Verschienung 8 nur zwei Stromschienen auf. Sind dagegen diese beiden Leistungshalbleitermodule 2 und 4 elektrisch in Reihe geschaltet und bilden ein Phasenmodul eines Stromrichters, so weist die Verschienung 8 drei Stromschienen auf. Wird das Stromrichtermodul als Phasenmodul verwendet, so sind die drei Stromschienen der Verschienung 8 eine Plus-, Last- und Minusstromschiene. Diese Stromschienen sind übereinander angeordnet, wobei jeweils zwischen zwei Stromschienen eine Isolierschicht angeordnet, und laminiert.

Diese Verschienung 8 ist auf den elektrischen Anschüssen eines jeden Leistungshalbleitermoduls 2 und 4 gesteckt. Bei diesen elektrischen Anschlüssen kann es sich um Lötstifte oder Schraubbolzen handeln. Ab einem vorbestimmten Leistungsvermögen des Leistungshalbleitermoduls 2, 4 weisen die Leistungshalbleitermodule 2, 4 als elektrische Anschlüsse nur noch Schraubbolzen auf. Entsprechend der Verschaltung der beiden Leistungshalbleitermodule 2, 4 sind deren Anschlüsse jeweils mit einer vorbestimmten Stromschiene der laminierten Verschienung 8 elektrisch leitend verbunden. Diese laminierte Verschienung 8 stützt sich nicht nur auf die Anschlüsse der Leistungshalbleitermodule 2, 4, sondern auch auf eine Mehrzahl von Stützelementen 18 ab. Diese sind entlang jeweils einer Längsseite des Stromrichtermoduls angeordnet.

Da als Kühlkörper dieses Stromrichtermoduls ein Flüssigkeits-Kühlkörper 6 vorgesehen ist, weist dieser einen Kühlmittelzulauf 20 und einen Kühlmittelablauf 22 auf. Mit diesen Kühlmittelzu- und -abläufen 20 und 22 ist das Stromrichtermodul mit einem Kühlmittelkreislauf flüssigkeitsmäßig verbunden. Als Kühlflüssigkeit kann jede Flüssigkeit, insbesondere Leitungswasser, verwendet werden.

Da die Stromtragfähigkeit der im Stromrichtermodul verwendeten Leistungshalbleitermodule 2, 4 stetig zunimmt, steigt auch der Strom in den Stromschienen der laminierten Verschienung 8 an. Dies hat eine quadratische Zunahme der Verluste in der laminierten Verschienung 8 zur Folge. Dadurch steigt die Temperatur in der laminierten Verschienung 8 an. Wie hoch die Grenztemperatur an der laminierten Verschienung 8 sein kann, hängt von den verwendeten Materialien ab. Das heißt, das Laminiermaterial der Verschienung 8 setzt die Temperaturgrenze fest. Das bedeutet für Stromrichteranwendungen eine Leistungsbegrenzung, die nicht mehr durch die eingesetzten Leistungshalbleitermodule 2, 4, sondern durch die materialspezifische Grenztemperatur eines Laminiermaterials bestimmt wird.

Um die in der laminierten Verschienung 8 entstandene Verlustleistung abführen zu können, ist diese Verschienung 8 mit einer Kühlmittelleitung 24 versehen (FIG. 2). Diese Kühlmittelleitung 24 ist kühlmittelmäßig mit dem Flüssigkeitskreislauf des Flüssigkeits-Kühlkörpers 6 verbunden. Der Flüssigkeitskreislauf des Flüssigkeits-Kühlkörpers 6 wird als Primärkreislauf und der Flüssigkeitskreislauf der Kühlmittelleitung 24 als Sekundärkreislauf bezeichnet. Der Primär- und der Sekundärkreislauf können flüssigkeitsmäßig parallel oder in Reihe geschaltet sein.

Wegen der Übersichtlichkeit ist in der FIG 2 nur die Verschienung 8 mit einer Kühlmittelleitung 24 perspektivisch dargestellt, wobei die Elemente der Verschienung 8 und die Kühlmittelleitung 24 noch nicht miteinander laminiert sind. Wie bereits erwähnt, weist ein Stromrichtermodul als Phasenbaustein eines mehrphasigen Stromrichters zwei Leistungshalbleitermodule 2 und 4 auf, die elektrisch in Reihe geschaltet sind. Der Verbindungspunkt dieser Reihenschaltung zweier Leistungshalbleitermodule 2 und 4 bildet einen wechselspannungsseitigen Anschluss 10, insbesondere einen Last-Anschluss. Mit diesem Last-Anschluss 10 ist eine Stromschiene 26, auch bezeichnet als Laststromschiene, der Verschienung 8 elektrisch leitend verbunden. Die Gleichspannungs-Anschlüsse 12 und 14 des Stromrichtermoduls sind jeweils mit einer Stromschiene 28 bzw. 30 elektrisch leitend verbunden, die auch als Plus- bzw. Minusstromschiene bezeichnet werden. Diese Stromschienen 26, 28 und 30 sind räumlich übereinander angeordnet, wobei jeweils zwischen zwei benachbarten Stromschienen 26, 28 bzw. 28, 30 eine Isolierschicht 32 angeordnet ist. Somit weist eine handelsübliche Verschienung eines Phasenmoduls wenigstens fünf Lagen auf. Damit diese Lagen zueinander mechanisch fixiert sind, ist dieser Stapel von drei Stromschienen 26, 28 und 30 und wenigstens zwei Isolierschichten 32 miteinander laminiert. Dadurch werden außerdem die geforderten Luft- und Kriechstrecken eingehalten.

In der perspektivischen Darstellung gemäß FIG 2 weist die Verschienung 8 nur drei Lagen auf, nämlich eine untere Lage, in der die Minus- und die Laststromschiene 30 und 26 angeordnet sind, eine Isolierlage, in der die Isolierschicht 32 angeordnet ist, und eine obere Lage, in der die Plusstromschiene 28 angeordnet ist. Auf der Oberfläche 34 der oberen bzw. unteren Stromschiene 28 bzw. 30 der Verschienung 8 ist keine zusätzliche Isolierschicht angeordnet. Die Isolierung dieser Oberflächen 34 wird vom Laminat übernommen.

Gemäß der Erfindung ist diese Verschienung 8 nun mit einer Kühlmittelleitung 24 versehen, die in dieser Darstellung der FIG 2 mäanderförmig auf der Oberfläche 34 der Plusstromschiene 28 verlegt ist. Diese Kühlmittelleitung 24 kann ebenfalls auf der Oberfläche 34 der unteren Stromschiene 30 mäanderförmig verlegt sein. Es ist auch möglich, dass jeweils eine Oberfläche 34 der oberen und der unteren Stromschiene 28 und 30 mit einer Kühlmittelleitung 24 versehen sind. Dabei sind die Mäander jeweils im Bereich der Anschlüsse der beiden Leistungshalbleitermodule 2 und 4 angeordnet. Anstelle einer Kühlmittelleitung 24 können auch zwei oder mehr Kühlmittelleitungen 24 auf die Verschienung 8, insbesondere auf der Oberfläche 34 der Plus- oder Minusstromschiene 28 oder 30, angeordnet sein. Wenn diese Verschienung 8 dazu genutzt wird, die beiden Leistungshalbleitermodule 2 und 4 mit den drei Anschlüssen 10 und 12 des Stromrichtermoduls elektrisch zu verbinden, ist es vorteilhaft, wenn zwei Kühlmittelleitungen 24 vorgesehen sind. Diese beiden Kühlmittelleitungen 24 sind derart auf der Oberfläche 34 der Plusstromschiene 28 der Verschienung 8 angeordnet, dass jeweils eine Kühlmittelleitung 24, insbesondere deren Mäander, in Flucht eines Leistungshalbleitermoduls 2 bzw. 4 auf der Verschienung 8 angeordnet sind. Das heißt, die Mäander einer jeden Kühlmittelleitung 24 sind jeweils in einem Bereich der Oberfläche 34 der Plus-stromschiene 28 angeordnet, die ein darunter angeordnetes Leistungshalbleitermodul 2 bzw. 4 abdeckt. Damit jede Kühlmittelleitung 24 unabhängig voneinander einen Bereich der Verschienung 8 entwärmen kann, sind diese beiden Kühlmittelleitungen 24 flüssigkeitsmäßig parallel geschaltet. Außerdem sind die beiden Kühlmittelleitungen 24 flüssigkeitsmäßig mit dem Flüssigkeits-Kühlkörper 6 des Stromrichtermoduls verbunden. Da zur Kühlung der Verschienung 8 nur ein Bruchteil der Kühlflüssigkeit des Primärkreislaufs benötigt wird, ist der Kühlkreislauf der Verschienung 8, der als Sekundärkreislauf bezeichnet wird, flüssigkeitsmäßig parallel zum Primärkreislauf geschaltet. Das heißt, ein Ende der Kühlmittelleitung 24 ist mit dem Kühlmittelzulauf 20, wogegen das andere Ende der Kühlmittelleitung 24 mit dem Kühlmittelablauf 22 des Primärkreislaufs verknüpft ist. Ein Vorteil dieser Verbindung zweier Kühlmittelkreisläufe besteht darin, dass das Stromrichtermodul anschlussseitig unverändert bleibt.

Da gemäß der perspektivischen Darstellung der Verschienung 8 mit einer Kühlmittelleitung 24 gemäß FIG 2 die Oberfläche 34 der Plusstromschiene 28 der Verschienung 8 nicht mit einer Isolierschicht versehen ist, muss die Kühlmittelleitung 24 aus einem isolierenden, aber thermisch gut leitenden Material sein, da das Kühlmittel, das durch die Kühlmittelleitung 24 fließt, potentialbehaftet ist. Ist eine Isolierschicht auf dieser Oberfläche 34 vorhanden, muss die Kühlmittelleitung nicht isolierend sein. Damit sich die Elemente der Verschienung 8 beim Laminieren nicht räumlich zueinander verschieben, sind diese räumlich fixiert. Dies gilt ebenfalls für die Kühlmittelleitung 24. Diese wird auf der Oberfläche 34 der Plusstromschiene 28 der Verschienung 8 in ihrer Lage fixiert. Dazu kann diese Kühlmittelleitung 24 mit dieser Oberfläche 34 verklebt sein. Durch das Laminieren erhält man eine kühlbare Verschienung 8, die wie eine handelsübliche laminierte Verschienung gehandhabt werden kann. Durch das Laminieren erhält der Stapel aus Stromschienen 26, 28 und 30, einer Isolierschicht 32 und der Kühlmittelleitung 24 eine mechanische Festigkeit.

Durch diese auf der Verschienung 8 aufgebrachte Kühlmittelleitung 24 wird die Verschienungstemperatur herabgesetzt, wodurch die verwendeten Leistungshalbleitermodule 2 und 4 leistungsmäßig ausgeschöpft werden können. Das heißt, das Stromrichtermodul weist gegenüber einem Stromrichtermodul ohne gekühlte Verschienung 8 eine höhere Leistung auf, da die Leistung dieses Stromrichtermoduls nicht mehr durch eine maximale Grenztemperatur eines verwendeten Laminiermaterials der Verschienung 8, sondern durch das Leistungsvermögen der verwendeten Leistungshalbleitermodule 2 und 4 bestimmt wird.

## Patentansprüche

1. Stromrichtermodul mit wenigstens zwei Leistungshalbleitermodulen (2, 4), die thermisch leitend mit einem Flüssigkeits-Kühlkörper (6) mechanisch verbunden sind und die mittels einer Verschienung (8), die wenigstens zwei voneinander isolierte Stromschienen (26, 28, 30) aufweist, mit Anschlüssen (10, 12, 14) des Stromrichtermoduls elektrisch leitend verknüpft sind, **dadurch gekennzeichnet, dass** auf einer Oberfläche (34) einer Stromschiene (26,28,30) der Verschienung (8) wenigstens eine Kühlmittelleitung (24) angeordnet ist, und dass die Stromschienen (26,28,30) der Verschienung (8) und diese Kühlmittelleitung (24) miteinander laminiert sind.

2. Stromrichtermodul nach Anspruch 1, **dadurch gekennzeichnet, dass** die Kühlmittelleitung (24) flüssigkeitsmäßig mit dem Flüssigkeits-Kühlkörper (6) verknüpft ist.

3. Stromrichtermodul nach Anspruch 1, **dadurch gekennzeichnet, dass** die Kühlmittelleitung (24) entlang einer Oberfläche (34) der Verschienung (8) mäanderförmig angeordnet ist.

4. Stromrichtermodul nach Anspruch 1 mit einer Verschienung (8) mit zwei Kühlmittelleitungen (24), **dadurch gekennzeichnet, dass** jeweils eine Kühlmittelleitung (24) in Flucht eines Leistungshalbleitermoduls (2, 4) des Stromrichtermoduls angeordnet ist.

5. Stromrichtermodul nach Anspruch 4, **dadurch gekennzeichnet, dass** die beiden Kühlmittelleitungen (24) flüssigkeitsmäßig zueinander parallel geschaltet sind.

6. Stromrichtermodul nach Anspruch 4, **dadurch gekennzeichnet, dass** die beiden Kühlmittelleitungen (24) flüssigkeitsmäßig zueinander in Reihe geschaltet sind.

7. Stromrichtermodul nach einem der vorgenannten Ansprüche, **dadurch gekennzeichnet, dass** die Kühlmittelleitung (24) aus einem elektrisch nicht leitenden Kunststoff besteht.

## Claims

1. Power converter module comprising at least two power semiconductor modules (2, 4) which are mechanically connected to a liquid cooling body (6) in a thermally conductive manner and which are electrically conductively linked to connections (10, 12, 14) of the power converter module by means of a busbar arrangement (8) having at least two busbars (26, 28, 30) insulated from one another, **characterized in that** at least one coolant line (24) is arranged on a surface (34) of a busbar (26, 28, 30) of the busbar arrangement (8), and **in that** the busbars (26, 28, 30) of the busbar arrangement (8) and said coolant line (24) are laminated with one another.

2. Power converter module according to Claim 1, **characterized in that** the coolant line (24) is linked to the liquid cooling body (6) in terms of liquid.

3. Power converter module according to Claim 1, **characterized in that** the coolant line (24) is arranged in a meandering fashion along a surface (34) of the busbar arrangement (8).

4. Power converter module according to Claim 1 having a busbar arrangement (8), with two coolant lines (24), **characterized in that** a respective coolant line (24) is arranged in alignment with a power semiconductor module (2, 4) of the power converter module.

5. Power converter module according to Claim 4, **characterized in that** the two coolant layers (24), in terms of liquid, are connected in parallel with one another.

6. Power converter module according to Claim 5, **characterized in that** the two coolant lines (24), in terms of liquid, are connected in series with one another.

7. Power converter module according to any of the preceding claims, **characterized in that** the coolant line (24) consists of an electrically non-conductive plastic.

## Revendications

1. Module de redresseur, comprenant au moins deux modules (2, 4) de puissance à semi-conducteur, qui sont reliés mécaniquement d'une manière conductrice thermiquement à un refroidisseur (6) à liquide et qui sont connectés d'une manière conductrice de l'électricité à des bornes (10, 12, 14) du module de redresseur, au moyen d'un ensemble (8) qui a au moins deux barres (26, 28, 30) de courant isolées l'une de l'autre, **caractérisé en ce qu'**au moins un conduit (24) pour du fluide réfrigérant est disposé sur une surface (34) d'une barre (26, 28, 30) de courant de l'ensemble (8) et **en ce que** les barres (26, 28, 30) de courant de l'ensemble (8) et ce conduit (24) pour du fluide réfrigérant sont laminés l'un à l'autre.

2. Module de redresseur de courant suivant la revendication 1,
**caractérisé en ce que** le conduit (24) pour du fluide réfrigérant est combiné du point de vue du liquide au refroidisseur (6) à liquide.

3. Module de redresseur de courant suivant la revendication 1,
**caractérisé en ce que** le conduit (24) pour du fluide réfrigérant est disposé sinueusement le long d'une surface (34) de l'ensemble (8).

4. Module de redresseur de courant suivant la revendication 1, comprenant un ensemble (8) ayant deux conduits (24) pour du fluide réfrigérant, **caractérisé en ce que** respectivement un conduit (24) pour du fluide réfrigérant est aligné sur un module (2, 4) de puissance à semi-conducteur du module de redresseur de courant.

5. Module de redresseur de courant suivant la revendication 4,
**caractérisé en ce que** les deux conduits (24) pour du fluide réfrigérant sont, du point de vue du liquide, montés en parallèle entre eux.

6. Module de redresseur de courant suivant la revendication 4,
**caractérisé en ce que** les deux conduits (24) pour du fluide réfrigérant sont, du point de vue du liquide, montés en série l'un par rapport à l'autre.

7. Module de redresseur de courant suivant l'une des revendications précédentes,
**caractérisé en ce que** le conduit (24) pour du fluide réfrigérant est en une matière plastique non conductrice de l'électricité.
